# EUROPEAN PATENT APPLICATION

(11) **EP 4 404 587 A1**
(43) Date of publication of application: **24.07.2024**
(21) Application number: 22869901.3
(22) Date of filing: 08.09.2022
(51) Int. Cl.: H04R 17/00

(54) **PIEZOELECTRIC DEVICE**

(30) Priority: 14.09.2021 JP 2021149111
(71) Applicant: Nisshinbo Holdings Inc., Tokyo 103-8650 (JP); Nisshinbo Micro Devices Inc., Tokyo 103-8456 (JP)
(72) Inventor: MASUMOTO, Naoki, Fujimino-shi, Saitama 356-8510 (JP); KUCHIJI, Hiroyuki, Fujimino-shi, Saitama 356-8510 (JP); KIKUCHI, Toshikatsu, Fujimino-shi, Saitama 356-8510 (JP)
(74) Representative: M. Zardi & Co S.A.
(86) International application number: PCT/JP2022/033803
(87) International publication number: WO 2023/042754

(57) **Abstract**

A piezoelectric device (100) comprising a substrate (1) having a cavity (4), a piezoelectric film (3) covering the cavity (4) and being supported by the substrate (1), and electrodes (5a, 5b) disposed so as to sandwich the piezoelectric film (3). The piezoelectric film (3) has a convex-shaped or concave-shaped vibrating region (6) disposed on the cavity (4). The vibrating region (6) is configured by a single-layer piezoelectric film including a first region of the piezoelectric film (3a) composed of a first piezoelectric material and a second region of the piezoelectric film (3b) composed of a second piezoelectric material having a piezoelectric constant larger than a piezoelectric constant of the first piezoelectric material. A first electrode (5a) and a second electrode (5b) are disposed so as to sandwich the second region of the piezoelectric film, a first input signal is converted to a first output signal based on displacement at the second region of the piezoelectric film (3b) between these electrodes, and a piezoelectric device comprising a convex-shaped vibrating region with high power and high sensitivity is provided.

## Description

### TECHNICAL FIELD

The present invention relates to a piezoelectric device, such as an actuator, a sensor, and the like, that uses a piezoelectric material, and particularly relates to a piezoelectric device using a piezoelectric film laminated on a substrate.

### BACKGROUND ART

Conventionally, a bulk-type piezoelectric device formed by machining a piezoelectric material is used. Moreover, with the demand for miniaturization of a piezoelectric device, a piezoelectric device having a configuration in which a lower-layer electrode, a piezoelectric film, and an upper-layer electrode are laminated on a substrate having a cavity, and an input signal is converted to an output signal based on displacement of the piezoelectric film between the lower-layer electrode and the upper-layer electrode is used. The piezoelectric device having such a structure makes it possible to transmit and receive high-frequency signals such as ultrasonic waves by reducing the thickness of the piezoelectric film disposed between the lower-layer electrode and the upper-layer electrode. For the piezoelectric device to transmit and receive this type of ultrasonic waves, the application range is variously expanded to include an obstacle detection device mounted to a vehicle, an ultrasonic diagnostic apparatus for medical use, and the like.

As the application range of the piezoelectric device expands, there is a growing demand not only for the miniaturization of the piezoelectric device, but also for higher power and higher sensitivity. To realize higher sensitivity, a piezoelectric device comprising a convex-shaped vibrating region is proposed (Patent document 1, for example). Moreover, a piezoelectric device that suppresses variations in the output characteristic and has a higher sensitivity is proposed (Patent document 2).

### PRIOR ART DOCUMENT

### Patent Document

Patent Document 1: JP 2017-112612 A
Patent Document 2: JP 2020-191359 A

### SUMMARY OF THE INVENTION

### PROBLEM TO BE SOLVED BY THE INVENTION

The conventional piezoelectric device comprising a convex-shaped vibrating region has a higher sensitivity than that of a piezoelectric device comprising a common flat plate-shaped vibrating region. However, to further expand the application range of a piezoelectric device, even higher power and even higher sensitivity are required.

Thus, an object of the present invention is to provide a piezoelectric device comprising a convex-shaped vibrating region with high-power and high sensitivity.

### MEANS TO SOLVE THE PROBLEM

One embodiment of a piezoelectric device of the present invention has a configuration in which the piezoelectric device comprises a substrate having a cavity, a piezoelectric film covering the cavity and being supported by the substrate, and electrodes disposed so as to sandwich the piezoelectric film, the piezoelectric film has a convex-shaped or concave-shaped vibrating region disposed on the cavity, the vibrating region is configured by a single-layer piezoelectric film including a first region composed of a first piezoelectric material, and a second region composed of a second piezoelectric material having a piezoelectric constant larger than a piezoelectric constant of the first piezoelectric material, a first electrode and a second electrode are disposed so as to sandwich the piezoelectric film at the second region, and a first input signal is converted to a first output signal based on displacement of the piezoelectric film at the second region between the first electrode and the second electrode.

### EFFECTS OF THE INVENTION

According to the piezoelectric device of the present invention, since a region of a part of a piezoelectric film on a cavity, which region constitutes a vibrating region, is configured by a piezoelectric material with a larger piezoelectric constant, and electrodes are disposed to this region of the piezoelectric film, it is possible to convert an input signal to an output signal based on displacement being larger than that in a case in which the piezoelectric film is composed of only a piezoelectric material with a smaller piezoelectric constant and it is possible to provide a piezoelectric device with high-power and high sensitivity.

### BRIEF DESCRIPTION OF THE DRAWINGS

FIG. 1 is a schematic plan view of a piezoelectric device being one embodiment (Embodiment 1) of the present invention.
FIG. 2 is a schematic cross-sectional view of the piezoelectric device along a line A-A in FIG. 1.
FIG. 3 is a schematic plan view of a piezoelectric device being another embodiment (Embodiment 2) of the present invention.
FIG. 4 is a schematic cross-sectional view of the piezoelectric device along a line B-B in FIG. 3.

### EMBODIMENT FOR CARRYING OUT THE INVENTION

Next, embodiments of a piezoelectric device of the present invention will be described with reference to the drawings, but the present invention is not limited to these embodiments, so that members, materials, and the like to be described below can be variously changed within the scope of the gist of the present invention. Moreover, the size, positional relationship, and the like between the respective components are for convenience, so that they do not strictly reflect the actual situation.

In a piezoelectric device of the present invention, a piezoelectric film at a partial region (corresponding to a piezoelectric film at the second region) of a piezoelectric film located on a cavity and constituting a vibrating region is configured by a piezoelectric material with a piezoelectric constant larger than that of a piezoelectric film of another region (corresponding to a piezoelectric film at the first region) and electrodes are disposed to the piezoelectric film at this region. Therefore, displacement of the piezoelectric film becomes larger than that in a case in which the piezoelectric film is composed of only a piezoelectric material with a smaller piezoelectric constant, and it is possible to convert an input signal to an output signal based on a larger displacement. As a result, it is possible to provide a piezoelectric device with high-power and high sensitivity.

### (Embodiment 1)

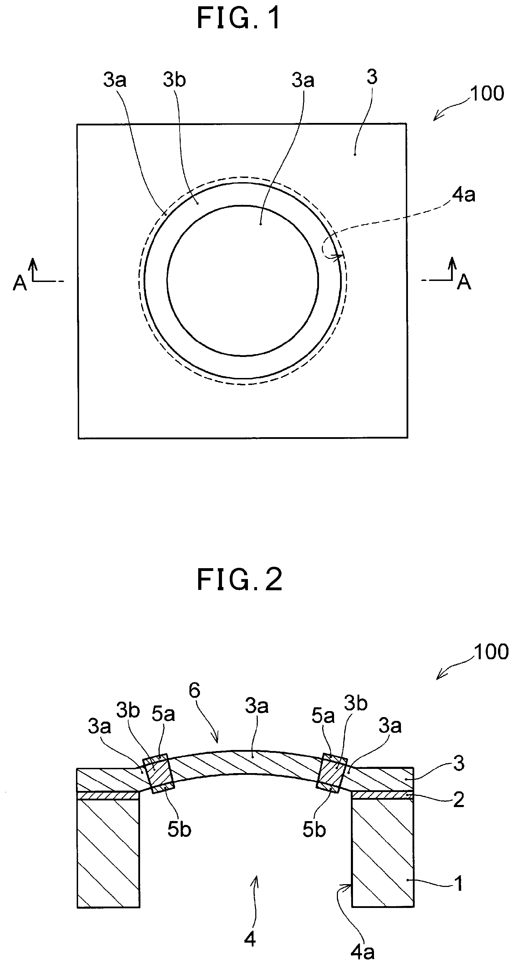

First, Embodiment 1 of the piezoelectric device of the present invention will be described. FIG. 1 shows a schematic plan view for explaining Embodiment 1 of the piezoelectric device of the present invention and FIG. 2 shows a schematic cross-sectional view of the piezoelectric device along a line A-A in FIG. 1, respectively. As shown in FIGS. 1 and 2, in a piezoelectric device 100 of the present embodiment, a piezoelectric film 3 is formed in a laminated manner on a substrate 1 via an insulating film 2. A part of the substrate 1 is removed and a cavity 4 being circularly shaped in planar view is formed therein. The piezoelectric film 3 is configured to have a single-layer structure having a thickness at which it can vibrate at a predetermined frequency. Moreover, a part of the piezoelectric film 3 located on the cavity 4 is configured to have a convex shape protruding in a direction opposite to the cavity 4. An end part of the piezoelectric film 3 is joined to the substrate 1 and supported by the substrate 1 via the insulating film 2.

The piezoelectric film on the cavity 4 has a configuration in which, as shown in FIG. 1, a part of a piezoelectric film at a first region 3a composed of a first piezoelectric material is removed in the shape of a donut and the piezoelectric film on the cavity 4 includes a piezoelectric film at a second region 3b composed of a second piezoelectric material filled in the removed part. Reference numeral 6 refers to a vibrating region of the piezoelectric film 3 located on the cavity 4, which is a combination of the first region and the second region. A region in which the piezoelectric film at the second region 3b is formed is to be a region in which a large displacement occurs when the above-mentioned vibrating region 6 vibrates, and is, specifically, a region proximate to a part where the piezoelectric film 3 is supported by the substrate 1 and along a wall portion 4a of the cavity 4 as shown in FIGS. 1 and 2.

On the front surface and the back surface of the piezoelectric-film-at the second region 3b, a first electrode 5a and a second electrode 5b are disposed so as to sandwich the piezoelectric film at the second region 3b. The first electrode 5a and the second electrode 5b are respectively connected to a voltage-applying unit not shown. In FIG. 1, the first electrode 5a disposed on the front surface of the piezoelectric film at the second region 3b is not shown.

As shown in FIG. 2, the piezoelectric film at the first region 3a and the piezoelectric film at the second region 3b on the cavity 4 (the vibrating region 6) have a convex shape protruding in a direction opposite to the cavity 4. To form the above-mentioned convex shape, the piezoelectric film 3 can be formed in a convex shape in advance, or a voltage can be applied between the first electrode 5a and the second electrode 5b to displace (extend) the piezoelectric film at the second region 3b to deform a flat piezoelectric film 3 into a convex shape. A part of the piezoelectric film 3 located on the cavity and formed in this manner, which is constituted by the piezoelectric film at the first region 3a and the piezoelectric film at the second region 3b, is to be the vibrating region 6 having a circular shape and protruding in a direction opposite to the cavity 4.

The piezoelectric device 100 described above can convert an input signal to an output signal as follows.

For example, when a voltage signal (corresponding to a first input signal) is applied between the first electrode 5a and the second electrode 5b, the piezoelectric film at the second region 3b is displaced. As a result, the piezoelectric film at the first region 3a is displaced along with the piezoelectric film at the second region 3b and the displacement is converted to a first output signal. Specifically, by changing the voltage-application direction at a predetermined frequency to apply a voltage signal between the first electrode 5a and the second electrode 5b, the piezoelectric film at the second region 3b extends or contracts, making it possible to vibrate the vibrating region 6 at a predetermined frequency (corresponding to the first output signal). Here, since the piezoelectric film at the second region 3b is composed of a piezoelectric material with a larger piezoelectric constant, displacement (vibration) of the piezoelectric film 3 of the vibrating region 6 becomes larger than that in a case of the overall vibrating region 6 being composed of only a piezoelectric material composing the piezoelectric film at the first region 3a, making it possible to generate a larger output signal.

Furthermore, as another example, when the vibrating region 6 vibrates (corresponding to the first input signal), the piezoelectric film at the second region 3b is displaced (extends or contracts). As a result, it is possible to obtain a desired voltage signal (corresponding to the first output signal) between the first electrode 5a and the second electrode 5b owing to the charge generated in the piezoelectric film at the second region 3b. Also in this case, since the piezoelectric film at the second region 3b being composed of a piezoelectric material with a larger piezoelectric constant, a larger amount of charge is generated and a voltage signal becomes larger compared with a case in which the vibrating region 6 is composed of only a piezoelectric material composing the piezoelectric film at the first region 3a. Therefore, it is possible to generate a large output signal. Alternatively, an output signal can be generated even for a small input signal.

### (Embodiment 2)

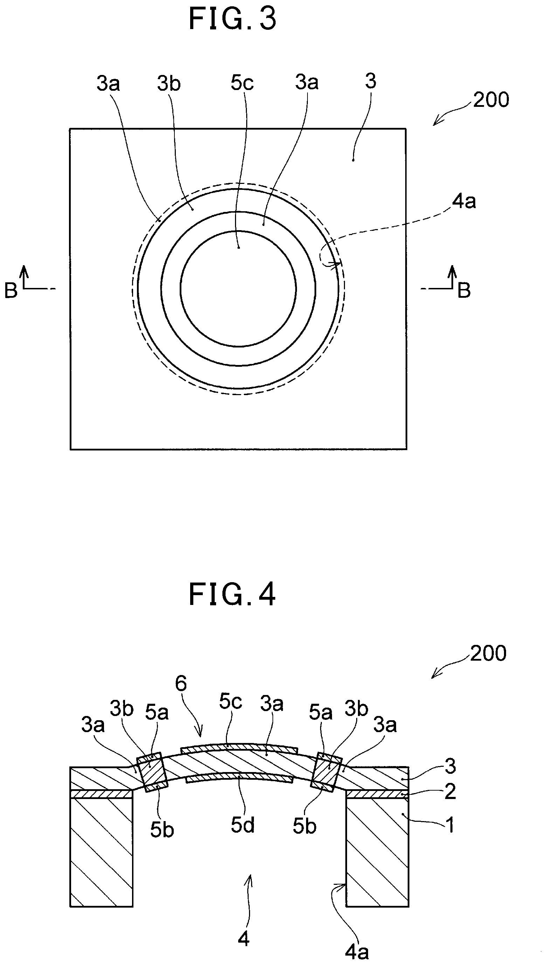

Next, Embodiment 2 of the piezoelectric device of the present invention will be described. FIG. 3 shows a schematic plan view for explaining Embodiment 2 of the piezoelectric device of the present invention and FIG. 4 shows a schematic cross-sectional view of the piezoelectric device along a line B-B in FIG. 3, respectively. As shown in FIGS. 3 and 4, in a piezoelectric device 200 of the present embodiment, a piezoelectric film 3 is formed in a laminated manner on a substrate 1 via an insulating film 2. A part of the substrate 1 is removed and a cavity 4 being circularly shaped in planar view is formed therein. The piezoelectric film 3 is configured to have a single-layer structure having a thickness at which it can vibrate at a predetermined frequency. Moreover, a part of the piezoelectric film 3 on the cavity 4 is configured to have a convex shape protruding in a direction opposite to the cavity 4. An end of the piezoelectric film 3 is joined to the substrate 1 and supported by the substrate 1 via the insulating film 2, and the cavity 4 is covered with the piezoelectric film 3.

The piezoelectric film on the cavity 4 has a configuration in which, as shown in FIG. 3, a part of a piezoelectric film at the first region 3a composed of a first piezoelectric material is removed in the shape of a donut and the piezoelectric film on the cavity 4 includes a piezoelectric film at the second region 3b composed of a second piezoelectric material filled in the removed part. Reference numeral 6 refers to a vibrating region of the piezoelectric film 3 located on the cavity 4, which is a combination of the first region and the second region. A region in which the piezoelectric film at the second region 3b is formed is to be a region in which a large displacement occurs when the above-mentioned vibrating region 6 vibrates, and is, specifically, a region proximate to a part where the piezoelectric film 3 is supported by the substrate 1 and along a wall portion 4a of the cavity 4 as shown in FIGS. 3 and 4.

On the front surface and the back surface of the piezoelectric film at the second region 3b, a first electrode 5a and a second electrode 5b are disposed so as to sandwich the piezoelectric film at the second region 3b. Moreover, in the piezoelectric device 200 of the present embodiment, on the front surface and the back surface of the piezoelectric film at the first region 3a, a third electrode 5c and a fourth electrode 5d are disposed so as to sandwich the piezoelectric film at the first region 3a. The first electrode 5a and the second electrode 5b, and also the third electrode 5c and the fourth electrode 5d are respectively connected to a voltage-applying unit or a voltage-detecting unit not shown. In FIG. 3, the first electrode 5a disposed on the front surface of the piezoelectric film at the second region 3b is not shown.

As shown in FIG. 4, the piezoelectric film at the first region 3a and the piezoelectric film at the second region 3b on the cavity 4 (the vibrating region 6) have a convex shape protruding in a direction opposite to the cavity 4. To form the above-mentioned convex shape, the piezoelectric film 3 can be formed in a convex shape in advance, or a voltage can be applied between the first electrode 5a and the second electrode 5b to displace (extend) the piezoelectric film at the second region 3b to deform a flat piezoelectric film 3 into a convex shape. Moreover, a voltage can also be applied to the convex-shaped piezoelectric film at the first region 3a between the third electrode 5c and the fourth electrode 5d to slightly displace the piezoelectric film at the first region 3a to form a desired convex shape. A part of the piezoelectric film 3 located on the cavity and formed in this manner, which is constituted by the piezoelectric film at the first region 3a and the piezoelectric film at the second region 3b, is to be the vibrating region 6 having a circular shape and protruding in a direction opposite to the cavity 4.

The piezoelectric device 200 described above can convert a first input signal to a first output signal and convert a second input signal to a second output signal as follows.

For example, when a voltage signal (corresponding to a first input signal) is applied between the first electrode 5a and the second electrode 5b, the piezoelectric film at the second region 3b is displaced. As a result, the piezoelectric film at the first region 3a is displaced along with the piezoelectric film at the second region 3b and the displacement is converted to a first output signal. Specifically, by changing the voltage-application direction at a predetermined frequency to apply a voltage signal between the first electrode 5a and the second electrode 5b, the piezoelectric film at the second region 3b extends or contracts, making it possible to vibrate the vibrating region 6 at a predetermined frequency (corresponding to the first output signal). Here, since the piezoelectric film at the second region 3b is composed of a piezoelectric material with a larger piezoelectric constant, displacement (vibration) of the piezoelectric film 3 of the vibrating region 6 becomes larger than that in a case of the overall vibrating region 6 being composed of only a piezoelectric material composing the piezoelectric film at the first region 3a, making it possible to generate a larger output signal.

Moreover, when a sound pressure and the like are applied to the vibrating region 6 and vibrate (corresponding to the second input signal), the piezoelectric film at the first region 3a is displaced. As a result, it is possible to obtain a desired voltage signal (corresponding to the second output signal) between the third electrode 5c and the fourth electrode 5d owing to the charge generated in the piezoelectric film at the first region 3a. In this case, a piezoelectric material composing the piezoelectric film at the first region 3a has a piezoelectric constant being smaller than that of a piezoelectric material composing the piezoelectric film at the second region 3b. In other words, the piezoelectric material composing the piezoelectric film at the first region 3a has a capacitance being smaller than that of the piezoelectric material composing the piezoelectric film at the second region 3b.

In general, when a piezoelectric material is used to detect signals in the ultrasonic range, even higher sensitivity can be realized by using a piezoelectric material with a small dielectric constant. Therefore, when a piezoelectric device is configured as the piezoelectric device 200 of the present embodiment, a piezoelectric device can be configured that makes it possible to detect signals in the ultrasonic range with sensitivity even higher than that of the piezoelectric device 100 described in Embodiment 1 above.

In the piezoelectric device 100 of Embodiment 1 and the piezoelectric device 200 of Embodiment 2 that are described above, when aluminum nitride as a piezoelectric material composing the piezoelectric film at the first region 3a and lead zirconate titanate (PZT) as a piezoelectric material composing the piezoelectric film at the second region 3b are selected, for example, a piezoelectric device having the shape shown in FIGS. 1 to 4 can be easily formed. Moreover, higher power and higher sensitivity can be achieved in the piezoelectric device 100 of Embodiment 1, and sensitivity even higher than that of Embodiment 1 can be achieved in the piezoelectric device 200 of Embodiment 2.

While embodiments of the piezoelectric device of the present invention have been described above, it is needless to say that the present invention is not to be limited to the above-described embodiments. For example, the piezoelectric film at the second region 3b is not limited to having the shape of a donut. Moreover, a combination of a piezoelectric material composing the first piezoelectric film and a piezoelectric material composing the second piezoelectric film can be changed as needed. Furthermore, the piezoelectric film 3 can also be configured to have a concave shape protruding in a direction toward the cavity 4.

For this type of piezoelectric device, the frequency and the like of an output signal are determined by the thickness and the like of a piezoelectric film. Thus, a piezoelectric device that makes wide-band signal conversion possible can be obtained by combining piezoelectric devices whose frequency and the like of an output signal are different.

### (Conclusion)

(1) A piezoelectric device of the present invention, in one embodiment, comprises a substrate having a cavity; a piezoelectric film covering the cavity and being supported by the substrate; and electrodes disposed so as to sandwich the piezoelectric film, wherein the piezoelectric film has a convex-shaped or concave-shaped vibrating region disposed on the cavity, wherein the vibrating region is configured by a single-layer piezoelectric film including a first region composed of a first piezoelectric material, and a second region composed of a second piezoelectric material having a piezoelectric constant larger than a piezoelectric constant of the first piezoelectric material, wherein a first electrode and a second electrode are disposed so as to sandwich the piezoelectric film at the second region, and wherein a first input signal is converted to a first output signal based on displacement of the piezoelectric film at the second region between the first electrode and the second electrode.
   According to the piezoelectric device of the embodiment (1) above, since a region of a part of a piezoelectric film on a cavity, which region constitutes a vibrating region, is configured by a piezoelectric material with a larger piezoelectric constant, it is possible to convert an input signal to an output signal based on a larger displacement and it is possible to provide a piezoelectric device with high-power and high sensitivity.
(2) According to another embodiment, in the piezoelectric device in (1) above, a voltage to be the first input signal is applied between the first electrode and the second electrode and, based on displacement of the piezoelectric film at the second region, the voltage is converted to vibration to be the first output signal to be output from the vibrating region.
(3) According to yet another embodiment, in the piezoelectric device in (1) above, vibration to be the first input signal is generated in the vibrating region and, based on displacement of the piezoelectric film at the second region, the vibration is converted to a voltage to be the first output signal to be output between the first electrode and the second electrode.
(4) According to a further embodiment, in the piezoelectric device in (1) above, a third electrode and a fourth electrode are disposed so as to sandwich the piezoelectric film at the first region and a second input signal is converted to a second output signal based on displacement of the piezoelectric film at the first region between the third electrode and the fourth electrode.
   According to the piezoelectric device of the embodiment (4) above, even higher sensitivity can be realized by using a piezoelectric material with a small dielectric constant.
(5) According to another embodiment, in the piezoelectric device in (4) above, a voltage to be the first input signal is applied between the first electrode and the second electrode and, based on displacement of the piezoelectric film at the second region, the voltage is converted to vibration to be the first output signal to be output from the vibrating region; and vibration to be the second input signal is generated in the vibrating region and, based on displacement of the piezoelectric film at the first region, the vibration is converted to a voltage to be the second output signal to be output between the third electrode and the fourth electrode, thereby making it possible to generate vibration and detect vibration.

### REFERENCE SIGNS LIST

100, 200 PIEZOELECTRIC DEVICE
1 SUBSTRATE
2 INSULATING FILM
3 PIEZOELECTRIC FILM
3a PIEZOELECTRIC FILM AT THE FIRST REGION
3b PIEZOELECTRIC FILM AT THE SECOND REGION
4 CAVITY
5a FIRST ELECTRODE
5b SECOND ELECTRODE
5c THIRD ELECTRODE
5d FOURTH ELECTRODE
6 VIBRATING REGION

## Claims

1. A piezoelectric device comprising:
a substrate having a cavity;
a piezoelectric film covering the cavity and being supported by the substrate; and
electrodes disposed so as to sandwich the piezoelectric film,
wherein the piezoelectric film has a convex-shaped or concave-shaped vibrating region disposed on the cavity,
wherein the vibrating region is configured by a single-layer piezoelectric film including a first region composed of a first piezoelectric material, and a second region composed of a second piezoelectric material having a piezoelectric constant larger than a piezoelectric constant of the first piezoelectric material,
wherein a first electrode and a second electrode are disposed so as to sandwich the piezoelectric film at the second region, and
wherein a first input signal is converted to a first output signal based on displacement of the piezoelectric film at the second region between the first electrode and the second electrode.

2. The piezoelectric device according to claim 1,
wherein a voltage to be the first input signal is applied between the first electrode and the second electrode and, based on displacement of the piezoelectric film at the second region, the voltage is converted to vibration to be the first output signal to be output from the vibrating region.

3. The piezoelectric device according to claim 1,
wherein vibration to be the first input signal is generated in the vibrating region and, based on displacement of the piezoelectric film at the second region, the vibration is converted to a voltage to be the first output signal to be output between the first electrode and the second electrode.

4. The piezoelectric device according to claim 1,
wherein a third electrode and a fourth electrode are disposed so as to sandwich the piezoelectric film at the first region and a second input signal is converted to a second output signal based on displacement of the piezoelectric film at the first region between the third electrode and the fourth electrode.

5. The piezoelectric device according to claim 4,
wherein a voltage to be the first input signal is applied between the first electrode and the second electrode and, based on displacement of the piezoelectric film at the second region, the voltage is converted to vibration to be the first output signal to be output from the vibrating region; and
wherein vibration to be the second input signal is generated in the vibrating region and, based on displacement of the piezoelectric film at the first region, the vibration is converted to a voltage to be the second output signal to be output between the third electrode and the fourth electrode.
